# FASCICULE DE BREVET EUROPEEN

(11) **EP 2 636 066 B1**
(45) Date de publication et mention de la délivrance du brevet: **05.09.2018**
(21) Numéro de dépôt: 11785716.9
(22) Date de dépôt: 03.11.2011
(51) Int. Cl.: H01L 27/146, H01L 27/144

(54) **DETECTEUR DE RAYONNEMENT VISIBLE ET PROCHE INFRAROUGE**
DETEKTOR FÜR SICHTBARE UND NAHINFRAROT-STRAHLUNG
VISIBLE AND NEAR-INFRARED RADIATION DETECTOR

(30) Priorité: 03.11.2010 FR 1004318
(43) Date de publication de la demande: 11.09.2013
(73) Titulaire: Commissariat à l'Énergie Atomique et aux Énergies Alternatives, 75015 Paris (FR)
(72) Inventeur: CAZAUX, Yvon, F-38100 Grenoble (FR); GIFFARD, Benoit, F-38000 Grenoble (FR); HUGON, Xavier, 38470 Teche, (FR)
(74) Mandataire: Talbot, Alexandre
(86) Numéro de dépôt international: PCT/FR2011/000586
(87) Numéro de publication internationale: WO 2012/059656

(56) Documents cités:
- EP-A1- 0 809 298
- EP-A1- 2 117 047
- EP-A1- 2 180 513
- US-A1- 2004 032 518
- US-A1- 2004 125 222
- US-A1- 2007 187 794
- US-A1- 2009 200 589
- US-A1- 2010 026 865
- US-A1- 2010 044 821
- US-A1- 2010 102 366

## Description

### Domaine technique de l'invention

L'invention est relative à l'imagerie à faible niveau d'éclairement, et plus particulièrement à un détecteur de rayonnement dans le domaine visible et dans le domaine proche infrarouge.

### État de la technique

En vision nocturne ou à faible niveau d'éclairement, la quantité de lumière visible (de 0,4 µm à 0,7 µm en longueur d'onde) est généralement insuffisante pour réaliser une capture d'image classique. On utilise alors un capteur dont la réponse spectrale s'étend au-delà du spectre visible. Ainsi, la quantité de lumière captée est augmentée, ce qui permet d'obtenir une image plus détaillée.

En d'autres termes, on cherche un matériau de détection ayant une sensibilité élevée pour les longueurs d'onde λ supérieures à 0,7 µm, c'est-à-dire un matériau sensible à l'infrarouge, et plus particulièrement au proche infrarouge. Par définition, la sensibilité d'un capteur correspond au rapport du signal de sortie du détecteur sur l'intensité lumineuse incidente normalisée. Elle est fonction de la longueur d'onde. Le proche infrarouge correspond à la gamme spectrale de 0,7 µm à 1,8 µm de longueur d'onde environ.

Dans le domaine visible, le silicium présente des performances de détection élevées et constitue le matériau de base des capteurs d'image actuels. En revanche, compte tenu de sa largeur de bande interdite (1,1 eV), la sensibilité du silicium diminue dans le domaine du proche infrarouge entre 700 et 1000nm. Cette diminution peut être en partie compensée en augmentant l'épaisseur de la couche de silicium. A titre d'exemple, une couche en silicium de 10 µm d'épaisseur permet d'absorber près de 90 % d'un rayonnement à 0,65 µm de longueur d'onde. Par contre, pour λ = 0,9 µm, une couche de 100 µm d'épaisseur est nécessaire. Par ailleurs, le silicium est transparent aux rayonnements de plus de 1 µm de longueur d'onde. Son utilisation en tant que matériau de détection pour le proche infrarouge est donc limitée.

Les matériaux optimisés pour la détection de rayonnements proches infrarouges sont les matériaux semi-conducteurs à faible largeur de bande interdite (E_{G} < 0,8 eV), comme l'arséniure de gallium et d'indium (InGaAs) ou le germanium. Une couche d'InGaAs de 0,5 µm d'épaisseur permet par exemple d'absorber 90 % d'un flux lumineux à 0,9 µm de longueur d'onde.

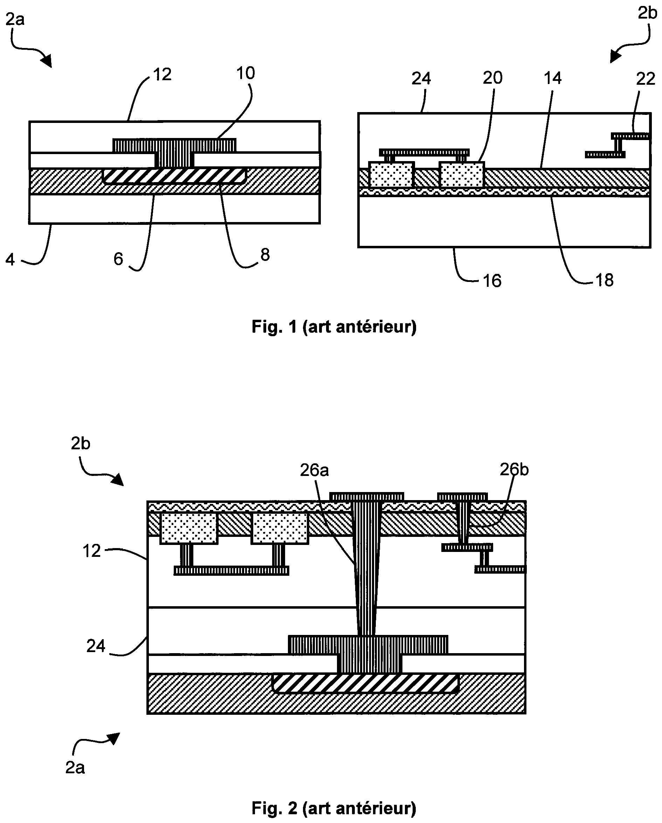

La figure 1 représente deux substrats 2a et 2b permettant de réaliser un capteur d'image à base d'InGaAs selon l'article [« Wafer-scale 3D intégration of InGaAs image sensors with Si readout circuits », Chen et al., IEEE International Conférence on 3D System Integration, 3DIC p.1-4, 2009].

Le substrat 2a, à gauche, comprend une couche 4 en phosphure d'indium (InP). La couche 4 d'InP permet la croissance par épitaxie d'un empilement 6 comprenant successivement une couche d'InP dopée de type n, une couche d'absorption en InGaAs intrinsèque et une couche d'InP intrinsèque. Par souci de clarté, les couches de l'empilement 6 ne sont pas représentées sur la figure 1. Une zone supérieure 8 de l'empilement 6 (correspondant à la couche d'InP intrinsèque) est localement dopée de type p de manière à former une diode PIN photosensible (p-InP/i-InGaAs/n-InP). Une métallisation 10 est déposée sur la zone 8 pour former un contact électrique de la photodiode. La métallisation 10 est ensuite recouverte d'une couche 12 en matériau diélectrique.

Le substrat 2b, à droite, est de type silicium sur isolant (SOI, « Silicon on insulator » en anglais). Il comprend une couche mince en silicium 14 séparée d'une couche de support 16 par une couche 18 d'oxyde enterré. Des transistors 20 sont formés dans la couche en silicium 14, puis reliés entre eux par des interconnexions 22 pour former un circuit de lecture. Une couche 24 en matériau diélectrique recouvre l'ensemble des transistors 20 et des interconnexions 22.

La figure 2 représente le capteur d'image à base d'InGaAs finalisé. Le substrat 2b muni du circuit de lecture est reporté par collage sur la photodiode du substrat 2a. Le collage s'effectue au niveau des couches diélectriques 12 et 24. La couche 4 d'InP et la couche de support 16 sont retirées. Enfin, la photodiode est reliée au circuit de lecture par des via d'interconnexion 26a et 26b.

Le capteur à base d'InGaAs représenté à la figure 2 est optimisé pour la détection en proche infrarouge. Par ailleurs, il est possible d'étendre la réponse spectrale de l'InGaAs dans le spectre visible en jouant sur les épaisseurs des couches des matériaux qui le constituent. Toutefois, les performances sont inférieures à celles du silicium. L'InGaAs n'est donc pas optimisé pour la détection visible.

Le brevet US5808350 décrit un capteur de rayonnement visible, proche infrarouge (NIR : « near-infrared ») et infrarouge (MWIR/LWIR : « mid/long wavelenght infrared »). Une couche en InGaAs est collée sur la face arrière d'un substrat en silicium pour former une hétérojonction. Un bolomètre, isolé thermiquement, est placé au-dessus de la face avant du substrat en silicium.

Le capteur est illuminé par la face arrière du substrat en silicium. Le rayonnement visible et proche infrarouge de 400 nm à 1800 nm est absorbé par la couche d'InGaAs tandis que le rayonnement infrarouge lointain (ou de moyenne longueur d'onde) traverse l'hétérojonction et le substrat en silicium, pour être capté par le bolomètre. Les charges photogénérées dans la couche d'InGaAs (visible et NIR) traversent l'hétérojonction et sont collectées dans le substrat en silicium.

Un tel capteur est complexe à réaliser. En particulier, la formation d'une hétérojonction InGaAs/Si pour détecter le rayonnement proche infrarouge est difficile à maîtriser. De plus, la délimitation de l'hétérojonction par gravure engendre d'importants courants de fuite.

Le document US2009/200589 décrit un capteur d'image visible et infrarouge éclairé en face arrière. Le capteur comprend un substrat en silicium dans lequel sont formés une photodiode visible et un circuit de lecture. Le substrat en silicium est surmonté d'une couche de détection infrarouge comprenant une photodiode en silicium amorphe hydrogéné (a-Si:H). Le rayonnement visible est absorbé par le substrat et capté par la photodiode en silicium. Le rayonnement infrarouge traverse le substrat, puis est capté par la photodiode en silicium amorphe hydrogéné. Le capteur est en outre muni de filtres couleurs.

Ce capteur visible et proche infrarouge ne présente pas de bonnes performances. En effet, le silicium amorphe hydrogéné a une sensibilité dans le proche infrarouge encore plus faible que celle du silicium cristallin. Ce type de matériau est d'ailleurs transparent au rayonnement de longueurs d'onde supérieures à 800 nm. De plus, ce capteur ne permet pas d'obtenir un bon rendu des couleurs.

Le document US2007/0187794 décrit un capteur d'image qui comporte des filtres permettant d'extraire des couleurs spécifiques. Le filtre peut inclure un filtre transparent, un filtre jaune et un filtre rouge. Le filtre transparent peut comporter un absorbeur de rayonnement infrarouge. Un bouclier au rayonnement infrarouge peut également être utilisé. Dans un autre mode de réalisation, un filtre de compensation est utilisé qui comporte une transmittance dans le rayonnement infrarouge supérieure à la transmittance dans le domaine visible. Enfin, le document propose d'utiliser un filtre infrarouge pour soustraire le signal infrarouge à partir d'un signal du pixel rouge et améliorer la reproductibilité du rouge.

Le document US 2004/032518 décrit un capteur face avant avec utilisation d'une résine « noire » pour former un pixel « noir ».

### Résumé de l'invention

On constate qu'il existe un besoin de prévoir un détecteur visible-proche infrarouge facile à réaliser et performant, notamment en termes de sensibilité et de rendu des couleurs.

On tend à satisfaire ce besoin en prévoyant un détecteur de rayonnement visible et proche infrarouge selon la revendication 1.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- la figure 1, précédemment décrite, représente deux parties constitutives d'un capteur proche infrarouge selon l'art antérieur ;
- la figure 2, précédemment décrite, représente un capteur proche infrarouge obtenu par assemblage des parties de la figure 1 ;
- la figure 3 représente un premier mode de réalisation d'un détecteur de rayonnement visible et proche infrarouge selon un exemple non revendiqué ;
- la figure 4 représente une variante de réalisation du détecteur de la figure 3 ;
- la figure 5 représente un schéma électrique d'un pixel correspondant au détecteur de la figure 4 ;
- la figure 6 représente quatre pixels d'un deuxième mode de réalisation de détecteur de rayonnement visible et proche infrarouge selon un exemple non revendiqué, trois des quatre pixels étant munis d'un filtre interférentiel associé à une couleur élémentaire ;
- la figure 7 représente quatre pixels d'une variante de réalisation du détecteur de la figure 6 ;
- la figure 8 représente quatre pixels d'un troisième mode de réalisation de détecteur de rayonnement visible et proche infrarouge selon l'invention, utilisant des filtres couleurs en résines pigmentées ;
- la figure 9 représente quatre pixels d'une variante de réalisation du détecteur de la figure 8 selon l'invention ;
- la figure 10 représente un schéma électrique d'un pixel couleur des figures 6, 7, 8 et 9 ; et
- la figure 11 représente quatre pixels d'une variante non revendiquée du détecteur couleur de la figure 9.

### Description d'un mode de réalisation préféré de l'invention

On souhaite disposer d'un détecteur combinant une image visible et une image dans le proche infrarouge (NIR : 0,7 µm < λ < 1,6 µm). Une telle association permet de visualiser une scène dans des conditions d'éclairement réduit.

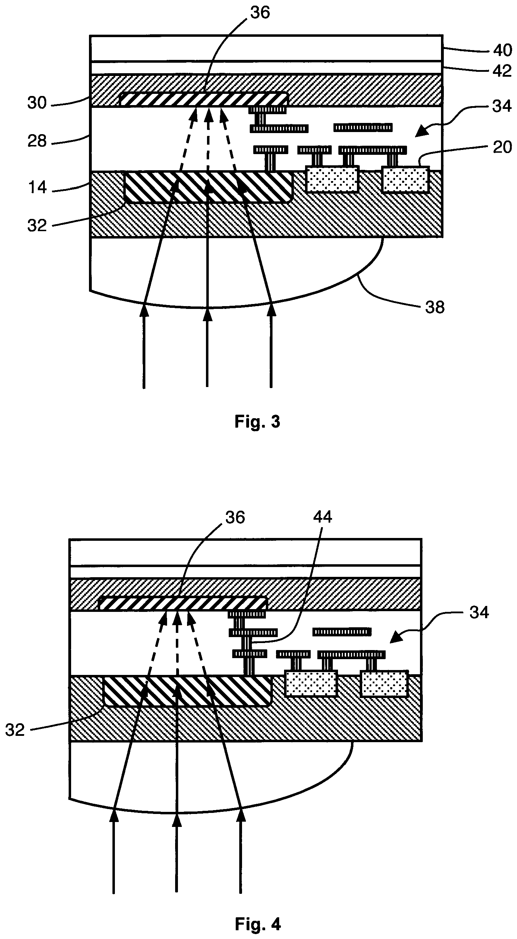

La figure 3 représente schématiquement un premier mode de réalisation d'un détecteur de rayonnement visible et proche infrarouge. Le détecteur comprend successivement un substrat 14 en silicium, une couche d'interconnexions 28 et un substrat 30 comprenant au moins une couche optimisée pour la détection du rayonnement proche infrarouge.

Le substrat 14 en silicium comprend une photodiode 32 et des transistors 20. Les transistors 20 sont formés sur une face avant du substrat 14 et recouverts par la couche d'interconnexions 28. La couche 28 se compose de pistes métalliques noyées dans un matériau diélectrique et transparent au rayonnement infrarouge, par exemple une couche d'oxyde de type PSG (PSG, « Phosphosilicate glass » en anglais). Les pistes métalliques interconnectent les transistors 20 et les relient électriquement avec la photodiode 32 pour former un circuit de lecture 34 de la photodiode 32.

Le substrat 30 comprend, de préférence, un empilement de couches en matériaux sensibles au proche infrarouge pour former une photodiode 36. L'empilement comprend par exemple une couche d'InP dopé de type n, une couche d'absorption en InGaAs intrinsèque et une couche d'InP dopé de type p. Dans ce cas, le maximum de sensibilité de la photodiode est défini par la couche d'absorption en InGaAs.

Dans ce mode de réalisation, la photodiode NIR 36 est associée à un circuit de lecture (non représenté sur la figure 3) formé dans le silicium 14 et distinct du circuit 34. Les porteurs de charge photogénérés issus des photodiodes 32 et 36 sont alors intégrés séparément. Les niveaux de luminosité des photodiodes sont lus séparément et peuvent être traités de manière indépendante, ou bien fusionnés à l'extérieur du détecteur, par exemple dans une mémoire externe. Le rayonnement visible et proche infrarouge, symbolisé par les flèches en trait plein sur la figure 3, entre dans le détecteur par une face arrière du substrat en silicium 14. La composante visible du rayonnement est captée par la photodiode 32.

Par contre, la composante du rayonnement correspondant au proche infrarouge traverse le substrat en silicium 14. Cette composante, schématisée par des flèches en traits pointillés sur la figure 3, est captée par la photodiode 36, disposée en regard de la photodiode 32. L'épaisseur du substrat 14 est, de préférence, comprise entre 2 µm et 5 µm, pour limiter l'absorption du proche infrarouge dans le silicium.

En d'autres termes, le rayonnement reçu par la face arrière du substrat 14 est divisé en deux parties. Chaque partie est captée par une photodiode optimisée pour le rayonnement considéré, c'est-à-dire une photodiode ayant une sensibilité élevée. Sur la figure 3, la photodiode silicium 32 est optimisée pour le rayonnement visible et la photodiode 36 à base d'InGaAs est optimisée pour le rayonnement proche infrarouge. Ainsi, le signal combiné issu du détecteur est plus intense par rapport à un capteur constitué uniquement de silicium ou d'InGaAs, dans des conditions de faible éclairement.

Les pistes métalliques de la couche 28 sont décalées vers un bord des zones photosensibles. Ainsi, on évite d'obstruer le passage de la lumière et on diminue la quantité de rayonnement réfléchi par les pistes métalliques.

Le détecteur comprend, de préférence, une microlentille 38 disposée sur la face arrière du substrat 14, qui focalise le rayonnement visible et proche infrarouge sur les photodiodes 32 et 36. Une couche anti-reflet (non représentée) peut également être placée sur la face arrière afin de maximiser la quantité de lumière reçue par les photodiodes.

L'épaisseur du substrat 30 est généralement comprise entre 0,5 µm et 5 µm. Le substrat 30 est, de préférence, renforcé par un substrat de soutien 40, par exemple en silicium, isolé électriquement du substrat 30 par une couche de passivation 42.

La figure 4 représente une variante de réalisation du détecteur dans laquelle les photodiodes 32 et 36 sont reliées entre elles par une connexion électrique 44. Le circuit de lecture 34 est alors partagé entre les photodiodes 32 et 36. Les charges générées par les photodiodes 32 et 36 sont sommées, réalisant ainsi directement et de manière simple la fusion du niveau de lumière visible et du niveau de lumière proche infrarouge.

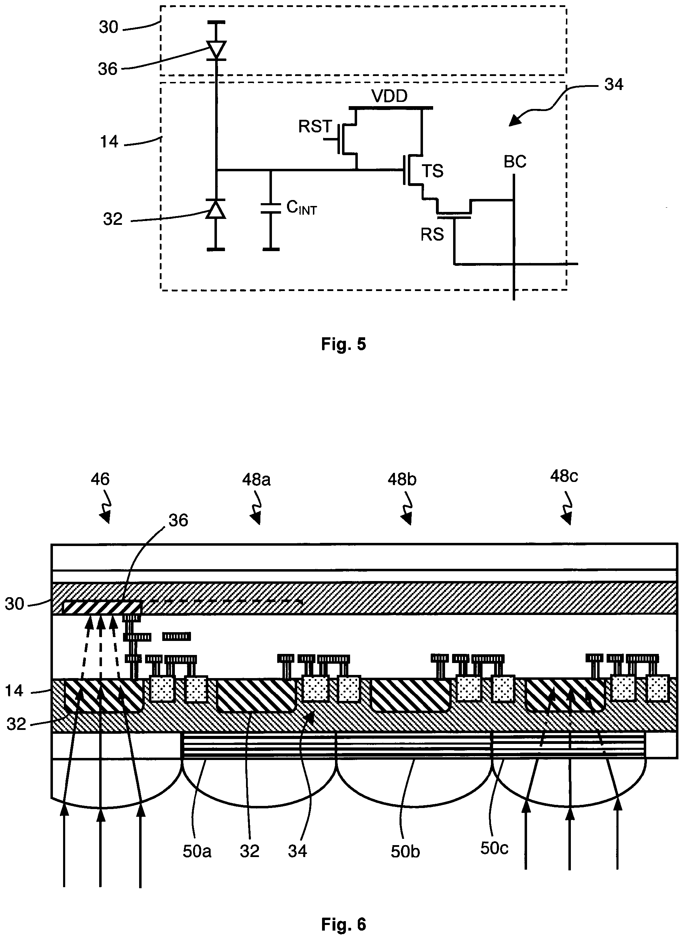

La figure 5 représente un schéma électrique d'un pixel correspondant au détecteur de la figure 4. Le pixel comprend la photodiode 32 du substrat 14 et la photodiode 36 du substrat 30, disposées tête-bêche et polarisées en inverse. Les photodiodes sont dans ce cas reliées à un circuit de lecture 34 de type classique composé de trois transistors : un transistor suiveur TS, un transistor de sélection de ligne RS et un transistor de réinitialisation RST.

Les cathodes des photodiodes 32 et 36 sont connectées à la grille du transistor suiveur TS. Les capacités intrinsèques des photodiodes 32, 36 et la capacité de grille du transistor TS, connectées électriquement en parallèle, sont réunies en une seule capacité d'intégration, notée C_{INT} sur la figure 5. La capacité C_{INT} permet d'accumuler les charges générées par la lumière visible et proche infrarouge qui frappe les photodiodes 32 et 36. Le transistor de sélection RS relie la source du transistor suiveur TS à un bus de colonne BC. Le transistor de réinitialisation RST relie la capacité C_{INT} à une ligne d'alimentation positive VDD.

Un amplificateur à transimpédance capacitif (« Capacitive Transimpedance Amplifier » en anglais, CTIA) peut également être utilisé en tant que circuit de lecture d'une ou plusieurs photodiodes. Un circuit de type CTIA est intéressant car il permet d'obtenir une polarisation stable des photodiodes, un faible niveau de bruit et une bonne linéarité. Il est particulièrement avantageux pour la photodiode NIR 36 dont le courant inverse tend à augmenter rapidement avec la tension de la jonction. Par contre, il occupe une surface du pixel plus importante que le circuit de lecture 34 illustré à la figure 5.

Les photodiodes 32 et 36 peuvent également être lues de façon séquentielle par le circuit de lecture 34. Dans ce cas, des transistors supplémentaires sont disposés en série avec les photodiodes, pour connecter successivement la photodiode 32 et la photodiode 36 au circuit de lecture 34.

Le détecteur de la figure 3 ou 4 est, de préférence, reproduit plusieurs fois de manière à constituer une matrice de pixels. Le capteur d'image ainsi obtenu superpose une matrice de photodiodes NIR à une matrice de photodiodes visibles. Les images visible et proche infrarouge, de résolution identique, sont fusionnées pour augmenter la sensibilité et la dynamique du détecteur dans des conditions d'éclairement réduit.

La figure 6 représente un deuxième mode de réalisation de détecteur de rayonnement visible et proche infrarouge permettant d'obtenir la couleur dans le spectre visible. Le détecteur comprend un quadruplet de pixels. Un premier pixel 46 comprend une photodiode visible 32, une photodiode NIR 36 et un circuit de lecture 34. Le pixel 46 correspond donc au détecteur de la figure 3 ou 4. Les trois autres pixels 48a, 48b et 48c comprennent chacun une photodiode visible 32 et un circuit de lecture 34 associé. Les pixels 48a, 48b et 48c sont munis respectivement de filtres 50a-50c associés aux trois couleurs élémentaires, par exemple le rouge (50a), le bleu (50b) et le vert (50c). Les filtres couleurs 50a-50c sont disposés entre le rayonnement incident et les photodiodes 32, en face arrière du substrat 14.

Dans un imageur couleur classique en silicium, le filtre au niveau de chaque pixel est généralement constitué d'une résine pigmentée. Ce type de filtre transmet une partie du rayonnement visible mais également une importante partie du rayonnement proche infrarouge auquel les photodiodes silicium sont sensibles jusqu'à environ λ=1 µm. Le proche infrarouge est généralement supprimé à l'aide d'un filtre global disposé en amont de la matrice de pixels. Cela permet de reconstituer une image couleur fidèle, le signal capté par les pixels dans le proche infrarouge pouvant être considéré comme un signal parasite qui s'ajoute aux signaux porteurs de l'information couleur. L'imageur couleur peut également être utilisé sans ce filtre global, en conditions de faible éclairement. Cela permet d'augmenter la dynamique de l'image en captant une partie du proche infrarouge dans les photodiodes silicium. Par contre, les couleurs de l'image sont faussées.

Le filtre global n'est pas utilisable dans les applications envisagées ici car on souhaite conserver le rayonnement proche infrarouge sur au moins un pixel pour augmenter la dynamique du détecteur.

Le filtre couleur 50a-50c est un filtre de type interférentiel, tel que décrit dans le brevet FR2904432. Le filtre interférentiel comprend une alternance de couches diélectriques (SiO₂, TiO₂, Al₂O₃...) et de couches métalliques (Ag, Al, Au...). La transmission du filtre est ajustée en faisant varier l'épaisseur d'une ou plusieurs couches diélectriques. Une particularité de ce type de filtre est que le rayonnement proche infrarouge peut être coupé, contrairement au filtre en résine pigmentée.

Ainsi, on définit des pixels couleurs 48a-48c ne recevant que le rayonnement visible (représenté en trait mixte sur la figure 6) et un pixel 46 dépourvu de filtre interférentiel et recevant à la fois le rayonnement visible et le rayonnement proche infrarouge.

En répétant ce quadruplet de pixels, on obtient une matrice de pixels 46 composites visible et proche infrarouge imbriquée dans une matrice de pixels couleurs 48a-48c. La matrice de pixels 46 produit une image en noir et blanc, avec un contraste élevé en captant davantage de lumière, tandis que la matrice de pixels 48a-48c produit une image visible en couleur. Ces deux images peuvent ensuite être fusionnées, le cas échéant.

Les informations de couleur dans le spectre visible améliorent l'intelligibilité de l'image et les informations dans le proche infrarouge augmentent la dynamique de l'image. Grâce aux filtres interférentiels, les couleurs obtenues sont fidèles à celles de la scène, contrairement à un imageur classique dépourvu de filtre global.

Dans une variante de réalisation du détecteur de la figure 6, le détecteur comprend une photodiode infrarouge 36 dans le pixel 46 et une photodiode infrarouge 36 dans au moins un des pixels couleurs 48a-c. La photodiode 36 du pixel couleur, ne voyant pas l'infrarouge à cause du filtre interférentiel 50a-c, permet alors de mesurer le courant d'obscurité des photodiodes infrarouges. Ce courant d'obscurité peut ensuite être retranché au signal du pixel infrarouge.

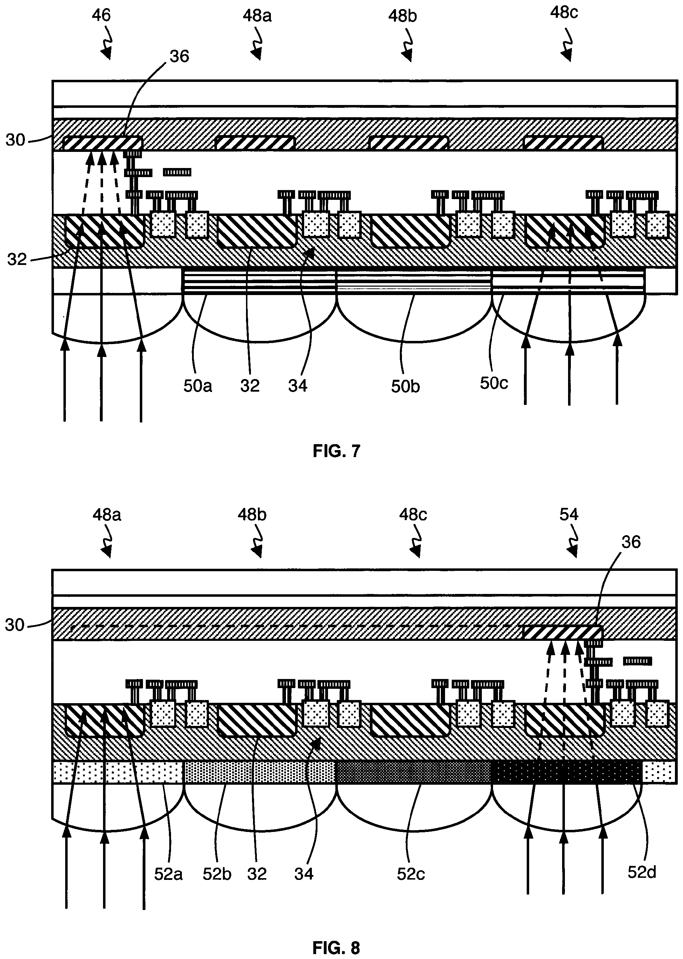

La figure 7 représente une autre variante de réalisation, dans laquelle le détecteur comprend quatre photodiodes 36 alignées sur quatre photodiodes 32. Cela permet de simplifier le procédé de fabrication, puisqu'on réalise tous les pixels de manière identique. Toutefois, les photodiodes 36 des pixels couleurs 48a-48c sont inactives puisque ces pixels sont munis de filtres individuels 50a-50c bloquant le proche infrarouge. Elles peuvent donc être déconnectées des circuits de lecture 34. Les laisser connectées permet d'augmenter la capacité d'intégration, si cela est souhaité dans certaines applications. On peut également prévoir de connecter les photodiodes 36 des pixels 48a-48c à une tension de polarisation fixe, ce qui élimine l'impact de leur courant de fuite sur la photodiode 36 du pixel 46.

A performances égales, notamment en ce qui concerne les contraintes de stockage de charges électriques, une photodiode NIR 36 en InGaAs est notablement plus grande qu'une photodiode silicium 32. Ainsi, si on réalise un capteur comme celui représenté sur la figure 7, comprenant des pixels de structure identique, on n'atteint pas, pour la partie visible, la résolution spatiale maximale permise par le silicium.

Afin d'augmenter la résolution spatiale dans le visible, plutôt que d'avoir des photodiodes 36 inactives dans les pixels couleurs 48a-48c, on étend au moins partiellement la photodiode 36 du pixel 46 sur au moins un des pixels 48a-48c (représentée en traits pointillés sur la figure 6), et de préférence, sur les trois pixels 48a-48c. Dans ce cas, la taille de la photodiode NIR peut être optimale tout en réduisant la taille des photodiodes visibles. De plus, cela augmente la capacité de stockage des charges de la photodiode 36, ce qui permet de repousser le seuil de saturation de la photodiode infrarouge et donc d'augmenter la dynamique de détection.

Chaque quadruplet ne comportant qu'un seul pixel proche infrarouge 46, la résolution spatiale de l'image proche infrarouge (noir et blanc) est divisée par quatre par rapport à un détecteur constitué uniquement de pixels proche infrarouge (Fig.3 ou 4).

La figure 8 représente un deuxième mode de réalisation de détecteur couleur et proche infrarouge, plus simple à mettre en oeuvre. Les filtres interférentiels de la figure 6 sont ici remplacés par des filtres colorés 52 en résine, transparents au rayonnement proche infrarouge.

Le détecteur comprend quatre photodiodes visibles 32 et une photodiode infrarouge 36, celle-ci étant alignée avec l'une des photodiodes visibles. Trois pixels 48a-48c comprennent respectivement trois des quatre photodiodes visibles 32 et un quatrième pixel 54 comprend la photodiode infrarouge 36 et la photodiode 32 restante. Les pixels 48a-48c sont en outre munis d'un filtre en résine associé à une couleur élémentaire 52a-52c et le quatrième pixel 54 est muni d'un filtre noir 52d.

Le rayonnement visible et proche infrarouge traverse les filtres 52a-52c. Dans les pixels 48a-48c, la composante visible filtrée est captée par la photodiode 32 et la composante proche infrarouge est perdue. A l'inverse, dans le pixel 54, le filtre noir 52d bloque le visible et seule la composante proche infrarouge du rayonnement est captée par la photodiode 36.

Ce détecteur permet, comme celui de la figure 6, de fusionner une image visible en couleur (obtenue par les pixels 48a-48c) avec une image proche infrarouge (obtenue par le pixel 54) pour augmenter la sensibilité dans des conditions d'éclairement réduit.

Le filtre noir 52d est constitué d'une résine pigmentée réalisée selon les mêmes techniques que les filtres couleur en résine 52a-52c, par exemple telle que décrite dans le brevet US5619357. La résine comporte un polymère et au moins un pigment apte à bloquer le rayonnement visible. Le polymère est, par exemple, choisi parmi les acryliques, les polyparaphénylènes vinylènes, les polyanilines, les polyazines, les polythiophènes, les polyparaphénylènes, les polyfurannes et les polypyrroles. Le pigment est, de préférence, un carbone fluoré noir. Le filtre noir est alors simple à réaliser. Un mélange de pigments peut également être employé, par exemple des parts égales de pigments jaune, violet et bleu ou des parts égales de pigments jaune et violet. De préférence, le pigment jaune est à base de composés d'isoindoline, le pigment violet à base de composés de dioxazine et le pigment bleu est à base de composés de phthalocyanine de cuivre.

La photodiode 36 du pixel 54 peut également s'étendre sur les trois pixels couleurs 48a-c (représentée en traits pointillés sur la figure 8). Dans cette configuration, le rayonnement infrarouge dans les pixels couleurs 48a-c n'est plus perdu comme sur la figure 8, mais capté par la photodiode 36. Cela permet une collecte maximale du flux infrarouge, pour augmenter encore la sensibilité.

Toutefois, dans le mode de réalisation de la figure 8, la résolution des images proches infrarouges est faible puisque le détecteur ne comprend qu'une seule photodiode 36 par quadruplet de pixels.

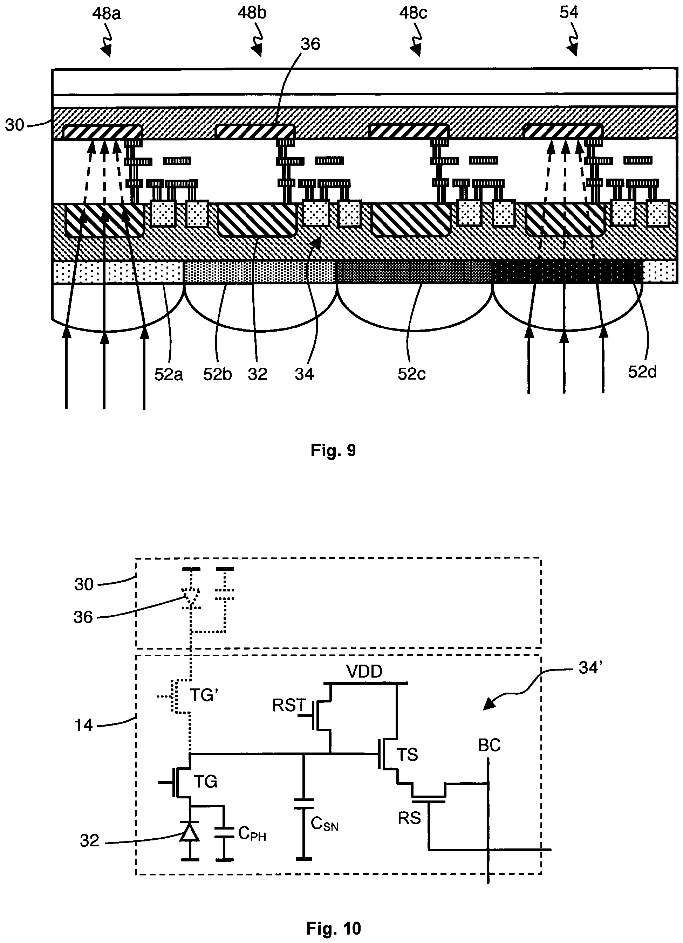

La figure 9 représente une variante de réalisation du détecteur couleur selon la figure 8, permettant de quadrupler la résolution spatiale des pixels NIR.

Le détecteur comprend quatre photodiodes 36 alignées sur quatre photodiodes 32. Les quatre pixels sont de structure identique, chacun comprenant une photodiode visible 32, une photodiode NIR 36 et un circuit de lecture 34.

Dans ce mode de réalisation, l'image proche infrarouge possède une résolution maximale, contrairement aux détecteurs des figures 6 à 8. En effet, chaque pixel comprend une photodiode 36 exposée au rayonnement proche infrarouge.

Les détecteurs des figures 8 et 9 peuvent également être utilisés en vision de jour et de nuit. En vision de jour, le détecteur est utilisé en capteur d'image couleur à l'aide des pixels 48a-48c. Pour reconstituer une image avec des couleurs fidèles, on soustrait la composante proche infrarouge du pixel 54 aux signaux issus des pixels couleurs 48a-48c, pour n'obtenir que la composante visible. En vision de nuit, la photodiode 36 forme un capteur d'image proche infrarouge, de simple résolution dans le cas de la figure 8 et de pleine résolution dans le cas de la figure 9.

Dans un cas pratique, le circuit de lecture 34 de la photodiode 32 (et de la photodiode 36 le cas échéant) est identique pour tous les pixels d'un détecteur. Le circuit à trois transistors (Fig. 5) et le circuit CTIA ont été précédemment décrits pour les pixels 46 captant à la fois le visible et le proche infrarouge. On pourra cependant envisager d'utiliser un circuit de lecture de nature différente pour les pixels couleurs 48a-48c des figures 6, 7, 8 et 9.

La figure 10 représente un circuit de lecture 34' optimisé pour les pixels couleurs 48a-48c. Le circuit de lecture 34' comprend un transistor supplémentaire par rapport au circuit 34 de la figure 5. La photodiode 32 est séparée du transistor suiveur TS par un transistor de transfert TG. Le transistor TG assure le transfert des charges intégrées dans la capacité intrinsèque C_{PH} de la photodiode vers la capacité de grille C_{SN} du transistor suiveur TS.

Ce circuit de lecture permet de minimiser le bruit temporel du pixel, en effectuant un double échantillonnage corrélé. Le principe consiste à lire le niveau de bruit dans la capacité C_{SN} avant de transférer le niveau utile de la photodiode 32 dans la capacité C_{SN}. On peut alors soustraire la valeur de bruit à la valeur du signal utile lu après transfert. En réduisant le bruit temporel, on améliore de façon significative la qualité d'image.

Lorsque le circuit de lecture 34' de la photodiode 32 est partagé avec une photodiode 36 (en traits pointillés sur la figure 10), par exemple dans le cas de la figure 9, un second transistor de transfert TG' est disposé entre la photodiode 36 et le transistor suiveur TS.

L'actionnement des transistors TG et TG' peut être réalisé simultanément ou successivement, selon le mode de lecture envisagé, simultané ou séquentiel. Dans le cas d'une lecture séquentielle, cela nécessite deux échantillonnages du niveau de bruit de la capacité C_{SN}, un avant chaque transfert.

Les anodes des photodiodes 32 sont, de préférence, connectées à un même potentiel (ligne commune à tous les pixels), de même que les anodes des photodiodes 36. Le potentiel fixé aux anodes des photodiodes 36 peut être différent de celui fixé aux anodes des photodiodes 32.

On constate qu'en omettant le substrat 30 du détecteur de la figure 9, on obtient une variante de capteur d'image couleur capable de détecter le rayonnement visible et proche infrarouge. Ce capteur est alors à base de silicium uniquement. Il ne vise donc pas des performances de détection élevées dans le proche infrarouge, contrairement aux précédents modes de réalisation. Par contre, il vise une grande simplicité de réalisation.

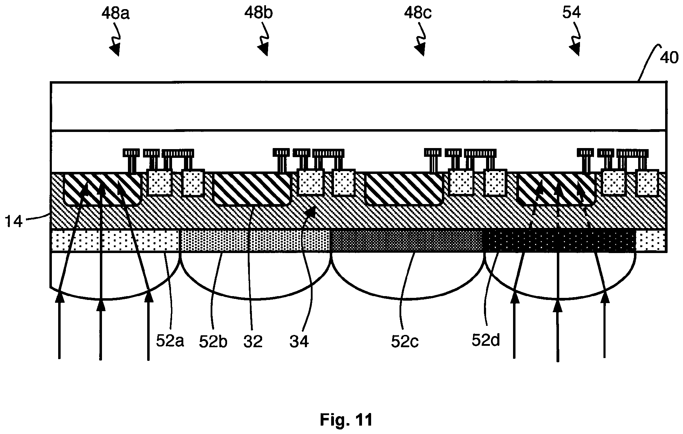

La figure 11 représente cette variante du capteur d'image couleur. Le capteur comprend quatre pixels munis de filtres en résines pigmentées 52a-52d. Trois pixels 48a-48c sont associés aux couleurs élémentaires RGB et un pixel 54 est dédié au proche infrarouge grâce au filtre 52d opaque au rayonnement visible. Chaque pixel comprend une photodiode 32 formée dans le substrat en silicium 14 et un circuit de lecture 34 de la photodiode 32. Le capteur peut être illuminé indifféremment par la face avant ou par la face arrière du substrat 14. Dans le cas d'un éclairement en face arrière (Fig.11), le substrat 14 est, de préférence, aminci puis renforcé par un substrat de soutien 40 disposé en face avant.

Le fonctionnement de ce capteur est semblable à celui de la figure 9. La composante proche infrarouge captée par le pixel 54 peut être retranchée aux signaux des pixels 48a-48c pour une vision de jour. En vision de nuit ou à faible éclairement, une partie du rayonnement proche infrarouge (700 nm - 1 µm) est captée par les photodiodes en silicium, mais la sensibilité est faible. Cela permet quand même d'obtenir une image en absence de lumière visible ou d'augmenter la sensibilité à faible niveau d'éclairement. L'absorption du proche infrarouge pourra par ailleurs être améliorée par l'utilisation d'un substrat 14 plus épais, entre 5 µm et 15 µm par exemple.

L'article [« A day and night MOS imager spectrally adjusted for a wide range of color », Koyama et al. ; Sensors, caméras, and systems for industrial/scientific applications X, 2009] décrit également un capteur d'image couleur visible et proche infrarouge en technologie silicium. Néanmoins, les filtres utilisés sont de type interférentiel et comprennent un nombre important de couches superposées. Ils sont de nature différente des filtres interférentiels décrits en relation avec la figure 6, car ils doivent laisser passer le proche infrarouge au lieu de le bloquer. De tels filtres sont complexes à concevoir et à réaliser.

Le capteur de la figure 11 utilise par contre des filtres en résines pigmentées facilement réalisables. Un capteur visible et proche infrarouge peut ainsi être obtenu à bas coût.

Un procédé de réalisation du détecteur visible et proche infrarouge selon la figure 3, 4, 6, 7, 8 ou 9 est décrit ci-après. Ce procédé s'inspire de la technique décrite en relation avec les figures 1 et 2.

Un substrat 30 comprenant des photodiodes optimisées pour la détection du proche infrarouge est réalisé. Les photodiodes NIR sont, de préférence, réalisées dans une couche d'InGaAs formée par épitaxie sur une couche d'InP. Une couche de métal est ensuite déposée sur la couche d'InGaAs, en face avant du substrat 30, pour former une métallisation de contact des photodiodes NIR (cathodes). La connexion des anodes des photodiodes NIR en face arrière du substrat 30 (couche d'InP) est, de préférence, ramenée en face avant par une métallisation sur un bord du substrat 30.

Un substrat 14 à base de silicium, de préférence de type SOI, est utilisé pour former les photodiodes visibles 32 et les transistors 20, selon les technologies CMOS. Une couche d'interconnexions 28 est ensuite formée sur la face avant du substrat 14 pour relier les transistors aux photodiodes 32. La couche d'interconnexions 28 comprend de manière classique plusieurs niveaux de métallisation recouverts de matériau diélectrique. Le denier niveau de métallisation n'est pas recouvert de matériau diélectrique. Une métallisation reste donc exposée en face avant du substrat 14.

Les substrats 30 et 14 sont ensuite mis en contact par leurs faces avant et assemblés par collage métal-métal. Le collage s'effectue entre le dernier niveau de métallisation de la couche 28 et la métallisation de contact des photodiodes NIR.

De préférence, le substrat 30 à base d'InP et d'InGaAs est renforcé par un substrat de soutien et le substrat 14 à base de silicium est aminci par gravure ou par polissage mécano-chimique. Dans le cas de la gravure, l'oxyde enterré du substrat SOI sert avantageusement de couche d'arrêt.

Enfin, des filtres (en résines pigmentées ou interférentiels) et des microlentilles peuvent être formés sur la face arrière du substrat 14, en correspondance avec les photodiodes visibles et proche infrarouge.

Dans les figures 1 et 2, les connexions entre les photodiodes NIR et les circuits de lecture se font par des vias pratiqués en face arrière et par un niveau de métallisation supplémentaire réalisé en face arrière du substrat 2b.

Dans le procédé décrit ci-dessus, l'interconnexion de la photodiode NIR et du circuit de lecture du substrat 14 est réalisée en face avant. On évite alors une reprise du capteur en face arrière pour réaliser des via d'interconnexions et des pistes métalliques supplémentaires.

De nombreuses variantes et modifications des modes de réalisation décrits ici apparaîtront à l'homme du métier. Par exemple, le matériau de la couche de détection du proche infrarouge n'est pas limité à l'InGaAs. D'autres matériaux semi-conducteurs ayant une largeur de bande interdite inférieure à 0,8 eV peuvent être utilisés, par exemple le tellurure de cadmium de mercure (CdHgTe), le germanium (Ge) et le silicium-germanium (SiGe).

## Revendications

1. Détecteur de rayonnement visible et proche infrarouge comprenant :
- un élément photosensible (36) dans le proche infrarouge,
- un circuit de lecture (34) de l'élément photosensible (36) dans le proche infrarouge formé sur une face avant d'un substrat en silicium (14),
- quatre éléments photosensibles (32) dans le visible formés dans le substrat en silicium (14), dont un premier élément photosensible dans le visible est disposé en regard de l'élément photosensible (36) dans le proche infrarouge, chaque élément photosensible (32) possédant une zone photosensible,
**caractérisé en ce que** l'élément photosensible (36) dans le proche infrarouge est formé dans une couche (30) en matériau optimisé pour la détection du proche infrarouge, la face avant du substrat en silicium étant recouverte par la couche (30) en matériau optimisé pour la détection du proche infrarouge, et **en ce que** le détecteur comporte :
- des pistes métalliques reliant électriquement le premier élément photosensible (32) avec le circuit de lecture (34), les pistes métalliques étant décalées vers les bords de ladite zone photosensible dudit premier élément photosensible (32), et les pistes métalliques étant formées entre la couche en matériau optimisé pour la détection du proche infrarouge et la face avant du substrat en silicium,
- quatre filtres en résines pigmentées en face arrière du substrat en silicium (14) de manière à définir un quadruplet de pixels dont un premier pixel (54), comprenant l'élément photosensible (36) dans le proche infrarouge et l'un des éléments photosensibles (32) dans le visible, est muni d'un filtre (52d) en résine opaque au rayonnement visible, et les trois autres pixels (48a-c), comprenant respectivement les trois autres éléments photosensibles (32) dans le visible, sont munis respectivement de trois filtres (52a, 52b, 52c) chacun desdits trois filtres correspondant respectivement à une couleur élémentaire.

2. Détecteur selon la revendication 1, **caractérisé en ce que** l'élément photosensible (36) dans le proche infrarouge du premier pixel (54) s'étend sur les trois autres pixels (48a-c).

3. Détecteur selon la revendication 1, **caractérisé en ce qu'**il comporte quatre éléments photosensibles (36) dans le proche infrarouge formés dans la couche (30) en matériau optimisé pour la détection du proche infrarouge, respectivement en regard des quatre éléments photosensibles dans le visible (32), d'où il résulte que chaque pixel (48a-c, 54) comprend un élément photosensible (32) dans le visible et un élément photosensible (36) dans le proche infrarouge.

4. Détecteur selon l'une quelconque des revendications 1 à 3, **caractérisé en ce que** la résine du filtre (52d) opaque au rayonnement visible comprend un polymère et au moins un pigment apte à bloquer le rayonnement visible.

5. Détecteur selon la revendication 4, **caractérisé en ce que** le polymère est choisi parmi les acryliques, les polyparaphénylènes vinylènes, les polyanilines, les polyazines, les polythiophènes, les polyparaphénylènes, les polyfurannes et les polypyrroles.

6. Détecteur selon l'une des revendications 4 et 5, **caractérisé en ce que** le pigment est un carbone fluoré noir.

7. Détecteur selon l'une des revendications 4 et 5, **caractérisé en ce que** la résine du filtre (52d) opaque au rayonnement visible comprend un mélange de pigments bleu, violet et jaune ou un mélange de pigments violet et jaune.

## Patentansprüche

1. Detektor für Strahlung im sichtbaren Bereich und im nahen Infrarot, welcher umfasst:
- ein im nahen Infrarot lichtempfindliches Element (36),
- eine Lese-Kreisschaltung (34) des im nahen Infrarot lichtempfindlichen Elements (36), welche auf einer vorderen Seite eines Substrats aus Silizium (14) gebildet ist,
- vier im sichtbaren Bereich lichtempfindliche Elemente (32), die in dem Substrat aus Silizium (14) gebildet sind, von denen ein erstes im sichtbaren Bereich lichtempfindliches Element gegenüber dem im nahen Infrarot lichtempfindlichen Element (36) angeordnet ist, wobei jedes lichtempfindliche Element (32) einen lichtempfindlichen Bereich besitzt,
**dadurch gekennzeichnet,**
**dass** das im nahen Infrarot lichtempfindliche Element (36) in einer Schicht (30) aus einem Werkstoff, der für die Erfassung des nahen Infrarot-Lichts optimiert ist, gebildet ist, wobei die vordere Seite des Substrats aus Silizium von der Schicht (30) aus Werkstoff, der für die Erfassung des nahen Infrarot-Lichts optimiert ist, bedeckt ist, und
**dass** der Detektor aufweist:
- metallische Bahnen, die das erste lichtempfindliche Element (32) mit der Lese-Kreisschaltung (34) verbinden, wobei die metallischen Bahnen zu den Rändern des genannten lichtempfindlichen Bereichs dieses ersten lichtempfindlichen Elements (32) hin verschoben sind, und wobei die metallischen Bahnen zwischen der Schicht aus Werkstoff, der für die Erfassung des nahen Infrarot-Lichts optimiert ist, und der vorderen Seite des Substrats aus Silizium gebildet sind,
- vier Filter aus pigmentierten Harzen an der hinteren Seite des Substrats aus Silizium (14) dergestalt, dass sie eine Vierfach-Anordnung von Pixeln bilden, von denen ein erstes Pixel (54), das das im nahen Infrarot lichtempfindliche Element (36) und eines der im sichtbaren Bereich lichtempfindlichen Elemente (32) enthält, mit einem Filter (52d) aus einem für Strahlung im sichtbaren Bereich undurchlässigen Harz versehen ist, und die drei anderen Pixel (48a-c), die jeweils eines der drei anderen im sichtbaren Bereich lichtempfindlichen Elemente (32) enthalten, mit drei Filtern (52a, 52b bzw. 52c) versehen sind, wobei jedes dieser drei Filter einer Hauptfarbe entspricht.

2. Detektor nach Anspruch 1,
**dadurch gekennzeichnet,**
**dass** das im nahen Infrarot lichtempfindliche Element (36) des ersten Pixels (54) sich über die drei anderen Pixel (48a-c) erstreckt.

3. Detektor nach Anspruch 1,
**dadurch gekennzeichnet,**
**dass** er vier im nahen Infrarot lichtempfindliche Elemente (36) enthält, die in der Schicht (30) aus einem Werkstoff, der für die Erfassung des nahen Infrarot-Lichts optimiert ist, gebildet sind, und zwar gegenüber den entsprechenden vier im sichtbaren Bereich lichtempfindlichen Elementen (32), woraus sich ergibt, dass jedes Pixel (48a-c, 54) ein im sichtbaren Bereich lichtempfindliches Element (32) und ein im nahen Infrarot lichtempfindliches Element (36) enthält.

4. Detektor nach einem der Ansprüche 1 bis 3,
**dadurch gekennzeichnet,**
**dass** das Harz des für Strahlung im sichtbaren Bereich undurchlässigen Filters (52d) ein Polymer sowie wenigstens ein Pigment, das geeignet ist, die Strahlung im sichtbaren Bereich zu sperren, enthält.

5. Detektor nach Anspruch 4,
**dadurch gekennzeichnet,**
**dass** das Polymer unter den Acryl-Stoffen, den Vinylen-Polyparaphenylenen, den Polyanilinen, den Polyazinen, den Polythiophenen, den Polyparaphenylenen, den Polyfuranen und den Polypyrrolen gewählt wird.

6. Detektor nach einem der Ansprüche 4 und 5,
**dadurch gekennzeichnet,**
**dass** das Pigment ein schwarzer, fluorierter Kohlenstoff ist.

7. Detektor nach einem der Ansprüche 4 und 5,
**dadurch gekennzeichnet,**
**dass** das Harz des für Strahlung im sichtbaren Bereich undurchlässigen Filters (52d) eine Mischung aus blauen, violetten und gelben Pigmenten oder eine Mischung aus violetten und gelben Pigmenten enthält.

## Claims

1. Detector of visible and near-infrared radiation comprising:
- a near-infrared photosensitive element (36),
- a readout circuit (34) for reading the near-infrared photosensitive element (36), formed on a frontside of a silicon substrate (14),
- four visible photosensitive elements (32) formed in the silicon substrate (14), one of the visible photosensitive elements being arranged in front of the near-infrared photosensitive element (36), each photosensitive element (32) having a photosensitive zone,
**characterized in that** the near-infrared photosensitive element (36) is formed in a layer (30) made of a material optimized for near-infrared detection, the frontside of the silicon substrate being covered with the layer (30) made of the material optimized for near-infrared detection and **in that** the detector comprises:
- metal tracks electrically connecting the first photosensitive element (32) with the readout circuit (34), the metal tracks are shifted to the edges of said photosensitive zone of said first photosensitive element (32), and the metal tracks are formed between the layer (30) made of a material optimized for near-infrared detection and the frontside of a silicon substrate,
- four pigmented resin filters at the backside of the silicon substrate (14) to define a pixel quadruplet, whereof a first pixel (54), comprising the near-infrared photosensitive element (36) and one of the visible photosensitive elements (32), is provided with a resin filter (52d) opaque to visible radiation, and the three other pixels (48a-c), respectively comprising the three other visible photosensitive elements (32), are respectively provided with three filters (52a, 52b, 52c) each of said three filters respectively corresponding to an elementary color.

2. Detector according to claim 1, **characterized in that** the near-infrared photosensitive element (36) of the first pixel (54) extends over the three other pixels (48a-c).

3. Detector according to claim 1, **characterized in that** it comprises four near-infrared photosensitive elements (36) formed in the layer (30) made of material optimized for near-infrared detection, respectively facing the four visible photosensitive elements (32), whereby each pixel (48a-c, 54) comprises one visible photosensitive element (32) and one near-infrared photosensitive element (36).

4. Detector according to any of claims 1 to 3, **characterized in that** the resin of the filter (52d) opaque to visible radiation comprises a polymer and at least one pigment capable of blocking visible radiation.

5. Detector according to claim 4, **characterized in that** the polymer is selected from among acrylics, polyparaphenylenes vinylenes, polyanilines, polyazines, polythiophenes, polyparaphenylenes, polyfurannes, and polypyrroles.

6. Detector according to any of claims 4 and 5, **characterized in that** the pigment is a black fluorinated carbon.

7. Detector according to any of claims 4 and 5, **characterized in that** the resin of the filter (52d) opaque to visible radiation comprises a mixture of blue, purple, and yellow pigments or a mixture of purple and yellow pigments.
